# EUROPÄISCHE PATENTSCHRIFT

(11) **EP 2 867 904 B1**
(45) Veröffentlichungstag und Bekanntmachung des Hinweises auf die Patenterteilung: **23.03.2016**
(21) Anmeldenummer: 13727807.3
(22) Anmeldetag: 05.06.2013
(51) Int. Cl.: H01C 1/148, H01C 7/13, G01R 1/20

(54) **WIDERSTAND, INSBESONDERE NIEDEROHMIGER STROMMESSWIDERSTAND**
RESISTOR, PARTICULARLY A LOW-RESISTANCE CURRENT-MEASURING RESISTOR
RÉSISTANCE, EN PARTICULIER RÉSISTANCE DE MESURE DE COURANT À FAIBLE IMPÉDANCE

(30) Priorität: 29.06.2012 DE 102012013036
(43) Veröffentlichungstag der Anmeldung: 06.05.2015
(73) Patentinhaber: Isabellenhütte Heusler GmbH & Co. Kg, 35683 Dillenburg (DE)
(72) Erfinder: HETZLER, Ullrich, 35688 Dillenburg-Oberscheld (DE)
(74) Vertreter: v. Bezold & Partner Patentanwälte - PartG mbB
(86) Internationale Anmeldenummer: PCT/EP2013/001648
(87) Internationale Veröffentlichungsnummer: WO 2014/000854

(56) Entgegenhaltungen:
- EP-A1- 0 824 258
- WO-A1-2006/119953
- GB-A- 2 321 558

## Beschreibung

Die Erfindung betrifft einen Widerstand, insbesondere einen niederohmigen Strommesswiderstand, sowie ein Beschichtungsverfahren zur Beschichtung eines derartigen Widerstands.

Aus EP 0 605 800 A1 ist ein niederohmiger Strommesswiderstand bekannt, der aus zwei plattenförmigen Anschlussteilen aus einem Leitermaterial (z.B. Kupfer) und einem zwischen die Anschlussteile eingesetzten plattenförmigen, niederohmigen Widerstandselement aus einem Widerstandsmaterial (z.B. Kupfer-Mangan-Nickel-Legierung) besteht, wobei der Spannungsabfall über dem Widerstandselement entsprechend dem Ohmschen Gesetz ein Maß für den durch den Strommesswiderstand fließenden elektrischen Strom bildet.

Problematisch bei einem solchen Strommesswiderstand ist die Tatsache, dass das Material der Anschlussteile und des Widerstandselements ohne eine Beschichtung oxidiert, so dass derartige Strommesswiderstände dann unschön, braun angelaufen aussehen, wobei durch die Oxidation auch die Lötbarkeit beeinträchtigt wird.

Zur Lösung dieses Problems ist es bekannt, das Verbundmaterialband, aus dem die vorstehend beschriebenen Strommesswiderstände ausgestanzt werden, galvanisch zu verzinnen oder zu vernickeln, so dass das Widerstandselement an den fertigen ausgestanzten Strommesswiderständen zumindest an der Oberseite und an der Unterseite mit einer Beschichtung versehen ist, die das störende Oxidieren verhindert. Allerdings hat das Aufbringen der Beschichtung vor dem Ausstanzen den Nachteil, dass die Stanzflanken und damit die Seitenkanten des Widerstandselements keine Beschichtung aufweisen und deshalb weiterhin einer Oxidation ausgesetzt sind.

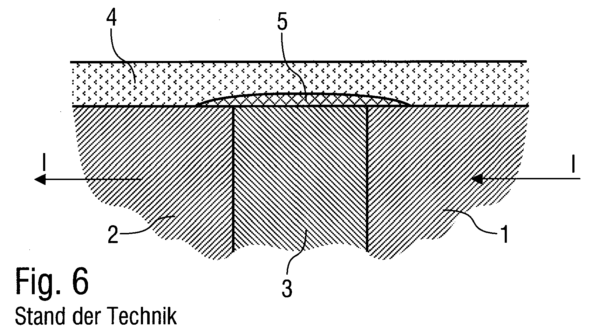

Bei strengen Kundenanforderungen bezüglich des Oberflächenschutzes erfolgte in der Vergangenheit eine galvanische Beschichtung des kompletten Strommesswiderstands, wie es in Figur 6 dargestellt ist. Der Strommesswiderstand gemäß Figur 6 entspricht dem Oberbegriff von Anspruch 1 und kann durch ein Beschichtungsverfahren gemäß dem Oberbegriff von Anspruch 9 hergestellt werden. Aus dieser Zeichnung ist ersichtlich, dass der Strommesswiderstand zwei Anschlussteile 1, 2 aufweist, wobei ein Widerstandselement 3 in Stromrichtung zwischen die beiden Anschlussteile, 1, 2 eingesetzt ist. Die Oxidation der Anschlussteile 1, 2 und des Widerstandselements wird hierbei durch eine metallische Beschichtung 4 verhindert, die galvanisch auf den Strommesswiderstand aufgebracht wird. Problematisch ist hierbei, dass die galvanische Beschichtung 4 elektrisch leitfähig ist und deshalb den elektrischen Widerstand des Widerstandselements 3 durch einen elektrischen Nebenschluss durch die Beschichtung 4 verfälschen kann. Zur Vermeidung einer derartigen Verfälschung des Widerstandswerts ist die freiliegende Oberfläche des Widerstandselements umlaufend mit einem elektrisch isolierenden Lack 5 beschichtet, der den störenden Nebenschluss über die metallische Beschichtung 4 verhindert. Auf diese Weise wird zwar die störende Oxidation der Oberflächen der Anschlussteile 1, 2 und des Widerstandselements 3 vollständig verhindert, jedoch ist das Aufbringen des Lacks 5 äußerst aufwändig und muss bisher manuell erfolgen.

Weiterhin ist zum Stand der Technik hinzuweisen auf DE 197 80 905 C2 bzw. GB 2 321 558 A, die einen anderen Widerstandstyp offenbart. Hierbei ist das Widerstandselement auf einen elektrisch isolierenden Träger aufgebracht und wird an seiner Oberseite von einer metallischen Beschichtung abgedeckt. Zum Einen hat die metallische Beschichtung hierbei jedoch einen geringeren Widerstandswert als das Widerstandselement und bildet deshalb einen erheblichen elektrischen Nebenschluss. Zum Anderen bleiben die Seitenkanten des Widerstandselements hierbei ebenfalls unbedeckt und können deshalb oxidieren.

Ferner ist zum Stand der Technik noch hinzuweisen auf EP 0 824 258 A1, WO 2006/119953 A1, US 2003/0016118 A1, DE 198 14 388 A1, DE 26 34 232 A1 und DE 260 70 26 A1.

Der Erfindung liegt deshalb die Aufgabe zugrunde, einen entsprechend verbesserten Widerstand zu schaffen. Diese Aufgabe wird durch einen erfindungsgemäßen Widerstand bzw. durch ein entsprechendes Beschichtungsverfahren gemäß den Nebenansprüchen gelöst.

Die Erfindung umfasst die allgemeine technische Lehre, dass die metallische Beschichtung ohne eine Isolationsschicht (z.B. Lack) direkt auf die gesamte freie Oberfläche des Widerstandselements aufgebracht wird. Dies bietet den Vorteil, dass das aufwändige manuelle Aufbringen der elektrisch isolierenden Lackschicht zwischen der metallischen Beschichtung und dem Widerstandselement entfallen kann, wodurch die Herstellung des erfindungsgemäßen Widerstands wesentlich einfacher wird. Der vorstehend erwähnte störende elektrische Nebenschluss an dem Widerstandselement vorbei durch die metallische Beschichtung hindurch kann im Rahmen der Erfindung durch verschiedene technische Maßnahmen verhindert bzw. auf ein nicht störendes Maß verringert werden.

Gemäß der Erfindung wird hierzu ein besonderes Material für die Beschichtung ausgewählt, das eine hinreichend kleine elektrische Leitfähigkeit bzw. einen hinreichend großen spezifischen elektrischen Widerstand aufweist. Vorzugsweise wird als Material für die metallische Beschichtung Nickel-Phosphor (NiP) verwendet, insbesondere mit einem Phosphorgehalt von ca. 6-8%. Es ist jedoch im Rahmen der Erfindung auch möglich, andere Metallbeschichtungen einzusetzen, die beispielsweise Nickel, Gold, insbesondere Flashgold, Silber, Palladium oder eine Legierung der vorstehend genannten Materialien enthalten können.

In jedem Fall weist das verwendete metallische Material für die Beschichtung einen größeren spezifischen elektrischen Widerstand auf als das Widerstandsmaterial des Widerstandselements.

Darüber hinaus kann der störende elektrische Nebenschluss durch die metallische Beschichtung auch dadurch minimiert werden, dass eine relativ dünne metallische Beschichtung eingesetzt wird. In dem bevorzugten Ausführungsbeispiel der Erfindung wird deshalb eine Nickel-Phosphor-Schicht mit einer Dicke von ca. 3 µm eingesetzt. Bei einer Beschichtung mit Flashgold ist die Schichtdicke der metallischen Beschichtung dagegen vorzugsweise kleiner als 2 µm. Allgemein lässt sich sagen, dass die Schichtdicke der metallischen Beschichtung vorzugsweise kleiner ist als 50 µm, 20 µm, 10 µm 5 µm, 1 µm, 500 nm oder sogar kleiner als 200 nm. Die metallische Beschichtung kann auch aus zwei Funktionsschichten bestehen, z.B. NiP und Flashgold.

Es wurde bereits vorstehend erwähnt, dass die metallische Beschichtung zu einem elektrischen Nebenschluss vorbei an dem Widerstandselement durch die metallische Beschichtung hindurchführt. Der erfindungsgemäße Widerstand ist hierbei vorzugsweise so ausgebildet, dass der Widerstandswert des Nebenschlusses über die metallische Beschichtung kleiner ist als 10%, 5%, 1%, 5‰ oder sogar kleiner als 2‰ des Widerstandswertes des Widerstandselements. Der Nebenschluss über die metallische Beschichtung ist also vorzugsweise so hochohmig in Bezug auf den Widerstandswert des Widerstandselements, dass der Nebenschluss eine Messung nicht verfälscht.

Darüber hinaus wird im Rahmen der Erfindung auch angestrebt, dass die metallische Beschichtung die Temperaturkonstanz des Widerstandswertes nicht oder nur in einem akzeptablen Ausmaß beeinträchtigt. Der erfindungsgemäße Widerstand ist deshalb vorzugsweise so ausgebildet, dass sich der Temperaturkoeffizient des Widerstandselements mit der Beschichtung nur geringfügig von dem Temperaturkoeffizienten ohne die metallische Beschichtung unterscheidet, wobei die Differenz vorzugsweise kleiner ist als 20%, 10%, 5% oder 1%.

Weiterhin ist zu erwähnen, dass die metallische Beschichtung das Widerstandselement vorzugsweise umlaufend ummantelt, d.h. auf der gesamten freien Oberfläche des Widerstandselements einschließlich der Seitenkanten. Dadurch unterscheidet sich der erfindungsgemäße Widerstand auch von den bekannten Widerständen, bei denen das Verbundmaterialband vor dem Ausstanzen der fertigen Strommesswiderstände verzinnt oder vernickelt wird, da die Stanzflanken des fertigen Strommesswiderstands dann unbeschichtet bleiben.

Vorzugsweise ummantelt die metallische Beschichtung sogar den kompletten Widerstand einschließlich der Anschlussteile und des Widerstandselements, wobei die Ummantelung vorzugsweise umlaufend ist und auch die Seitenkanten und Stirnkanten des Widerstands umfasst.

Darüber hinaus ist zu erwähnen, dass die metallische Beschichtung vorzugsweise aus einem Material besteht, das lötbar, schweißbar, bondbar und/oder korrosionsbeständig ist.

In dem bevorzugten Ausführungsbeispiel der Erfindung handelt es sich bei dem Leitermaterial um Kupfer oder eine Kupferlegierung, um einen möglichst niedrigen elektrischen Widerstand der Anschlussteile zu erreichen. Dies ist sinnvoll, damit bei einer Vierleitermessung (vgl. EP 0 605 800 A1) das Messergebnis nicht durch Spannungsabfälle innerhalb der Anschlussteile verfälscht wird.

Darüber hinaus ist zu erwähnen, dass das Widerstandsmaterial vorzugsweise eine Kupferlegierung ist, insbesondere eine Kupfer-Mangan-Nickel-Legierung, wie beispielsweise Cu84Ni4Mn12 (Manganin®). Es besteht jedoch alternativ auch die Möglichkeit, dass das Widerstandsmaterial des Widerstandselements eine Nickellegierung ist, wie beispielsweise NiCr oder CuNi.

Zu dem Leitermaterial und dem Widerstandsmaterial ist weiterhin zu erwähnen, dass das Widerstandsmaterial des Widerstandselements vorzugsweise einen größeren spezifischen elektrischen Widerstand aufweist als das Leitermaterial der Anschlussteile.

Hinsichtlich der konstruktiven Gestaltung des erfindungsgemäßen Widerstands ist zu erwähnen, dass das Widerstandselement elektrisch und mechanisch mit den beiden angrenzenden Anschlussteilen verbunden ist, insbesondere durch eine Schweißverbindung, wobei sich eine Elektronenstrahlverschweißung besonders eignet, wie beispielsweise in EP 0 605 800 A1 beschrieben ist.

In dem bevorzugten Ausführungsbeispiel der Erfindung sind die beiden Anschlussteile auf gegenüberliegenden Seiten des Widerstandselements angeordnet, so dass Einleitung und Ausleitung des elektrischen Stroms auf gegenüberliegenden Seiten des Widerstandselements erfolgt.

Es ist jedoch auch möglich, dass die beiden Anschlussteile auf derselben Seite des Widerstandselements angeordnet sind, so dass Einleitung und Ausleitung des elektrischen Stroms auf derselben Leite des Widerstandselements erfolgt.

Die beiden vorstehend beschriebenen Varianten sind detailliert auch in EP 0 605 800 A1 beschrieben, so dass der Inhalt dieser Druckschrift der vorliegenden Beschreibung in vollem Umfang zuzurechnen ist.

Bei dieser Gelegenheit ist auch zu erwähnen, dass die Anschlussteile und/oder das Widerstandselement vorzugsweise plattenförmig ausgebildet sind, was eine kostengünstige Herstellung aus einem Verbundmaterial ermöglicht, wie es beispielsweise in EP 0 605 800 A1 beschrieben ist.

Die plattenförmigen Anschlussteile und das plattenförmige Widerstandselement sind vorzugsweise eben und liegen in einer gemeinsamen Ebene, so dass der erfindungsgemäße Widerstand als ganzes ebenfalls eben ist.

Es besteht jedoch alternativ auch die Möglichkeit, dass die plattenförmigen Anschlussteile und/oder das plattenförmige Widerstandselement gebogen sind oder bei der stanztechnischen Herstellung gebogen bzw. den Anforderungen entsprechend geformt werden. Dadurch ist es möglich, dass das Widerstandselement im montierten Zustand von einer Leiterplatte beabstandet ist, was zu einer guten Kühlung des Widerstandselements führt oder den Einbau des Teils vereinfacht.

Darüber hinaus ist zu erwähnen, dass es sich bei dem erfindungsgemäßen Widerstand vorzugsweise um einen Widerstand für die Montage in Stromschienen handelt. Das Verfahren ist jedoch auch für sogenannte SMD-Widerstände (SMD: Surface Mounted Device) anwendbar, die zu einer Oberflächenmontage auf einer Leiterplatte geeignet sind.

Für einen Einsatz als Strommesswiderstand ist bekanntermaßen eine möglichst gute Temperaturkonstanz des Widerstandswerts erwünscht. Das verwendete Widerstandsmaterial weist deshalb vorzugsweise einen spezifischen elektrischen Widerstand mit einem sehr kleinen Temperaturkoeffizienten auf, der vorzugsweise kleiner ist als 5·10⁻⁴K⁻¹, 2·10⁻⁴K⁻¹, 1·10⁻⁴K⁻¹ oder 5·10⁻⁵K⁻¹.

Es wurde bereits vorstehend erwähnt, dass es sich bei dem Widerstandsmaterial vorzugsweise um ein niederohmiges Widerstandsmaterial handelt, weshalb der spezifische elektrische Widerstand des Widerstandsmaterial vorzugsweise kleiner ist als 2·10⁻⁴ Ωm, 2·10⁻⁵ Ωm oder 2·10⁻⁶ Ωm.

Das Leitermaterial der Anschlussteile weist dagegen vorzugsweise einen noch kleineren spezifischen elektrischen Widerstand von weniger als 10⁻⁵ Ωm, 10⁻⁶ Ωm oder 10⁻⁷ Ωm auf.

Schließlich ist noch zu erwähnen, dass die Erfindung nicht auf einen erfindungsgemäßen Widerstand als fertiges Bauteil beschränkt ist, sondern auch Schutz beansprucht für ein entsprechendes Beschichtungsverfahren, wobei der Ablauf des erfindungsgemäßen Beschichtungsverfahrens bereits aus der vorstehenden Beschreibung hervorgeht, so dass zur Vermeidung von Wiederholungen auf die vorstehende Beschreibung verwiesen wird.

Ergänzend ist zu dem Beschichtungsverfahren noch zu bemerken, dass die Beschichtung mit der metallischen Beschichtung galvanisch oder chemisch erfolgen kann, insbesondere durch ein Trommelbeschichtungsverfahren, was an sich aus dem Stand der Technik bekannt ist. Dabei werden die unbeschichteten Widerstände in einer Trommel rotierend galvanisch oder chemisch beschichtet. Andere Beschichtungsverfahren, wie Sputtern oder CVD (Chemical Vapor Deposition) etc. sind natürlich ebenfalls möglich.

Andere vorteilhafte Weiterbildungen der Erfindung sind in den Unteransprüchen gekennzeichnet oder werden nachstehend zusammen mit der Beschreibung des bevorzugten Ausführungsbeispiels der Erfindung anhand der Figuren näher erläutert. Es zeigen:
- Figur 1: eine Aufsicht auf einen erfindungsgemäßen Strommesswiderstand,
- Figur 2: eine Seitenansicht des Strommesswiderstands aus Figur 1,
- Figur 3: eine vergrößerte Querschnittsansicht des Strommesswiderstands aus den Figuren 1 und 2,
- Figur 4: ein Ersatzschaltbild für den erfindungsgemäßen Strommesswiderstand zur Verdeutlichung des elektrischen Nebenschlusses über die metallische Beschichtung des Widerstandselements,
- Figur 5: ein Diagramm zur Verdeutlichung der temperaturbedingten Widerstandsänderung, sowie
- Figur 6: eine vergrößerte Detailansicht entsprechend Figur 3 bei einem herkömmlichen Strommesswiderstand.

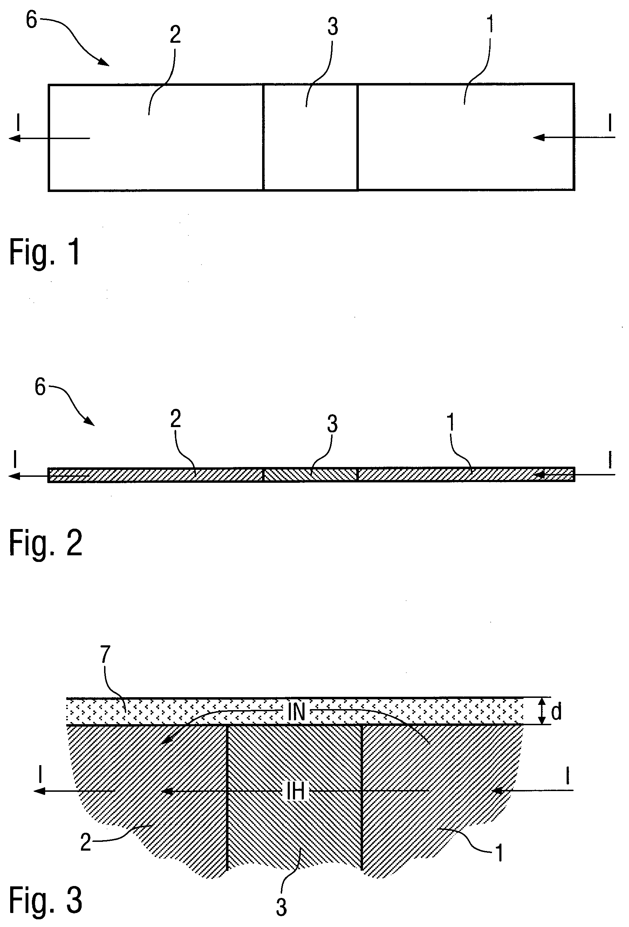

Die Figuren 1 bis 4 zeigen einen erfindungsgemäßen Strommesswiderstand 6, der weitgehend mit dem vorstehend beschriebenen und in Figur 6 dargestellten herkömmlichen Strommesswiderstand übereinstimmt, so dass zur Vermeidung von Wiederholungen auf die vorstehende Beschreibung verwiesen wird, wobei für entsprechende Einzelheiten dieselben Bezugszeichen verwendet werden.

Die beiden Anschlussteile 1, 2 sind hierbei jeweils plattenförmig ausgebildet und bestehen aus Kupfer oder einer Kupferlegierung.

Das Widerstandselement 3 ist ebenfalls plattenförmig ausgebildet und besteht aus einer Kupfer-Mangan-Nickel-Legierung, wie beispielsweise Cu84Ni4Mn12 (Manganin®).

Ansonsten wird hinsichtlich der Herstellung und des Aufbaus des erfindungsgemäßen Strommesswiderstands 1 auf die Druckschrift EP 0 605 800 A1 verwiesen, deren Inhalt deshalb der vorliegenden Beschreibung in vollem Umfang zuzurechnen ist.

Das Anschlussteil 1 dient hierbei zur Einleitung eines elektrischen Stroms I in den Strommesswiderstand 6, während das Anschlussteil 2 die Funktion hat, den elektrischen Strom I wieder aus dem Strommesswiderstand 6 abzuleiten.

Die freiliegende Oberfläche des Widerstandselements 3 ist hierbei umlaufend mit einer metallischen Beschichtung 7 beschichtet, die in diesem Ausführungsbeispiel aus Nickel-Phosphor mit einem Phosphorgehalt von 6-8% besteht.

Hierbei ist zu erwähnen, dass die metallische Beschichtung 7 nicht nur das Widerstandselement 3 ummantelt, sondern den kompletten Strommesswiderstand 6 einschließlich der beiden Anschlussteile 1, 2.

Die metallische Beschichtung 7 verhindert zum einen störende Oxidationen an der Oberfläche der Anschlussteile 1, 2 und des Widerstandselements 3. Darüber hinaus verbessert die metallische Beschichtung 7 aber auch die Lötbarkeit.

Hierbei ist zu erwähnen, dass sich der erfindungsgemäße Strommesswiderstand 6 von dem in Figur 6 dargestellten herkömmlichen Strommesswiderstand dadurch unterscheidet, dass die metallische Beschichtung 7 direkt auf die Oberflächen der Anschlussteile 1, 2 und des Widerstandselements 3 aufgebracht ist, d.h. ohne die dazwischen liegende Lackschicht 5 gemäß Figur 6. Dies bietet den Vorteil, dass auf das aufwändige manuelle Aufbringen der Lackschicht 5 verzichtet werden kann, was eine wesentlich einfachere Herstellung des erfindungsgemäßen Strommesswiderstands 6 ermöglicht.

Der ansonsten störende elektrische Nebenschluss vorbei an dem Widerstandselement 3 durch die metallische Beschichtung 7 hindurch wird hierbei durch verschiedene technische Maßnahmen verhindert.

Zum einen besteht die metallische Beschichtung 7 aus Nickel-Phosphor, was eine hinreichend niedrige elektrische Leitfähigkeit aufweist, wodurch der elektrische Nebenschluss über die metallische Beschichtung 7 stark verringert wird.

Darüber hinaus weist die metallische Beschichtung 7 eine äußerst geringe Schichtdicke d≈3µm auf, wodurch der Nebenschluss weiter verringert wird.

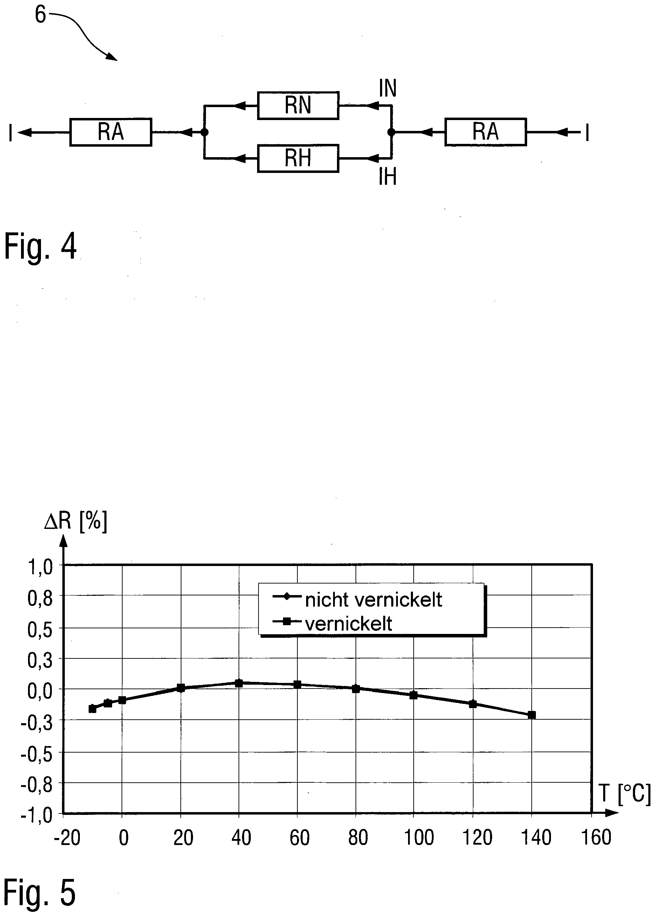

Figur 4 zeigt ein elektrotechnisches Ersatzschaltbild des erfindungsgemäßen Strommesswiderstandes 6 mit Widerständen RA für die Anschlussteile 1, 2, einem Widerstand RH für das Widerstandselement 3 und einem Widerstand RN für den Nebenschluss vorbei an dem Widerstandselement 3 durch die metallische Beschichtung 7 hindurch. Der zugeführte elektrische Strom I teilt sich deshalb auf in einen Hauptstrom IH durch das Widerstandselement 3 und einen Nebenschlussstrom IN durch die metallische Beschichtung 7 bzw. durch den Widerstand RN der metallischen Beschichtung 7. Der erfindungsgemäße Strommesswiderstand 6 ist hierbei so ausgebildet, dass der Nebenschlussstrom IN um mehrere Zehnerpotenzen kleiner ist als der Hauptstrom IH.

Figur 5 zeigt schließlich die temperaturbedingte Änderung des Gesamtwiderstands des erfindungsgemäßen Strommesswiderstands, und zwar zum einen für einen Rohzustand ohne die metallische Beschichtung 7 und zum anderen mit der metallischen Beschichtung 7, die hierbei aus Nickel besteht. Aus dem Diagramm ist ersichtlich, dass die Temperaturkonstanz durch die metallische Beschichtung 7 allenfalls unmerklich beeinträchtigt wird.

Die Erfindung ist nicht auf das vorstehend beschriebene bevorzugte Ausführungsbeispiel beschränkt. Vielmehr ist eine Vielzahl von Varianten und Abwandlungen möglich, die ebenfalls von dem Erfindungsgedanken Gebrauch machen und deshalb in den Schutzbereich fallen. Darüber hinaus beansprucht die Erfindung auch Schutz für den Gegenstand und die Merkmale der Unteransprüche unabhängig von den in Bezug genommenen Ansprüchen.

### Bezugszeichenliste

- 1: Anschlussteil
- 2: Anschlussteil
- 3: Widerstandselement
- 4: Metallische Beschichtung
- 5: Lack
- 6: Strommesswiderstand
- 7: Metallische Beschichtung
- d: Schichtdicke der metallischen Beschichtung
- RA: Widerstand der Anschlussteile
- RN: Widerstand des Nebenschlusses
- RH: Widerstand des Widerstandselements
- IH: Hauptstrom durch das Widerstandselement
- IN: Strom durch den Nebenschluss durch die metallische Beschichtung
- I: Gesamt-Strom

## Patentansprüche

1. Widerstand (6), insbesondere niederohmiger Strommesswiderstand, mit
a) einem ersten Anschlussteil (1) aus einem Leitermaterial zur Einleitung eines elektrischen Stroms (I) in den Widerstand (6),
b) einem zweiten Anschlussteil (2) aus einem Leitermaterial zur Ableitung des elektrischen Stroms (I) aus dem Widerstand (6),
c) einem Widerstandselement (3) aus einem Widerstandsmaterial, wobei das Widerstandselement (3) in Stromrichtung zwischen dem ersten Anschlussteil (1) und dem zweiten Anschlussteil (2) angeordnet ist,
d) einer Beschichtung (7) des Widerstands (6) aus einem metallischen Material, um einen Korrosionsschutz zu erreichen und/oder die Lötbarkeit zu verbessern,
**dadurch gekennzeichnet,**
e) **dass** die metallische Beschichtung (7) ohne eine Isolationsschicht (5) direkt auf die gesamte freie Oberfläche des Widerstandselements (3) aufgebracht ist, und
f) **dass** das metallische Material der Beschichtung (7) einen größeren spezifischen elektrischen Widerstand (6) aufweist als das Widerstandsmaterial des Widerstandselements (3).

2. Widerstand (6) nach Anspruch 1, **dadurch gekennzeichnet, dass** die metallische Beschichtung (7) eine Schichtdicke von weniger als 50µm, 20µm, 10µm, 5µm, 1µm, 500nm oder 200nm aufweist.

3. Widerstand (6) nach einem der vorhergehenden Ansprüche, **dadurch gekennzeichnet,**
a) **dass** die metallische Beschichtung (7) neben dem Widerstandselement (3) einen elektrischen Nebenschluss (IN) zwischen den beiden Anschlussteilen bildet,
b) **dass** der Nebenschluss (IN) über die metallische Beschichtung (7) einen bestimmten elektrischen Widerstandswert (RN) aufweist,
c) **dass** das Widerstandselement (3) zwischen den beiden Anschlussteilen einen bestimmten Widerstandswert (RH) aufweist,
d) **dass** der Widerstandswert (RN) des Nebenschlusses kleiner ist als 10%, 7%, 1%, 5‰ oder 2‰ des Widerstandswertes (RH) des Widerstandselements (3).

4. Widerstand (6) nach einem der vorhergehenden Ansprüche, **dadurch gekennzeichnet, dass** das metallische Material der Beschichtung (7) mindestens eines der folgenden Materialien enthält:
a) Nickel,
b) Nickel-Phosphor, insbesondere mit einem Phosphorgehalt von 6-8%,
c) Gold, insbesondere Flashgold,
d) Silber,
e) Palladium,
f) eine Legierung der vorstehend genannten Materialien.

5. Widerstand (6) nach einem der vorhergehenden Ansprüche, **dadurch gekennzeichnet,**
a) **dass** der Widerstand (6) ohne die metallische Beschichtung (7) einen elektrischen Widerstandwert mit einem bestimmten Temperaturkoeffizienten aufweist,
b) **dass** der Widerstand (6) mit der metallischen Beschichtung (7) einen elektrischen Widerstandwert mit einem bestimmten Temperaturkoeffizienten aufweist,
c) **dass** sich der Temperaturkoeffizient mit der Beschichtung (7) um weniger als 20%, 10%, 5% oder 1% von dem Temperaturkoeffizienten ohne die Beschichtung (7) unterscheidet.

6. Widerstand (6) nach einem der vorhergehenden Ansprüche, **dadurch gekennzeichnet, dass** die metallische Beschichtung (7) den Widerstand (6) komplett ummantelt einschließlich der Anschlussteile (1, 2) und des Widerstandselements (3).

7. Widerstand (6) nach einem der vorhergehenden Ansprüche, **dadurch gekennzeichnet, dass** die metallische Beschichtung (7) lötbar, schweißbar, bondbar und/oder korrosionsbeständig ist.

8. Widerstand (6) nach einem der vorhergehenden Ansprüche, **dadurch gekennzeichnet,**
a) **dass** das Leitermaterial der Anschlussteile (1, 2) Kupfer oder eine Kupferlegierung ist, und/oder
b) **dass** das Widerstandsmaterial des Widerstandselements (3) eine Kupferlegierung ist, insbesondere eine Kupfer-Mangan-Nickel-Legierung, insbesondere Cu84Ni4Mn12, und/oder
c) **dass** das Widerstandsmaterial des Widerstandselements (3) eine Nickellegierung ist, insbesondere NiCr oder CuNi, und/oder
d) **dass** das Widerstandselement (3) elektrisch und mechanisch mit den beiden Anschlussteilen (1, 2) verbunden ist, insbesondere durch eine Schweißverbindung, und/oder
e) **dass** die beiden Anschlussteile (1, 2) auf gegenüberliegenden Seiten des Widerstandselements (3) angeordnet sind, und/oder
f) **dass** die Anschlussteile (1, 2) und/oder das Widerstandselement (3) plattenförmig sind, und/oder
g) **dass** die plattenförmigen Anschlussteile (1, 2) und/oder das plattenförmige Widerstandselement (3) eben oder gebogen sind, und/oder
h) **dass** das Widerstandsmaterial einen spezifischen elektrischen Widerstand mit einem Temperaturkoeffizienten von weniger als 5·10⁻⁴K⁻¹, 2·10⁻⁹K⁻¹, 1·10⁻⁴K⁻¹ oder 5·10⁻⁵K⁻¹ aufweist, und/oder
i) **dass** das Widerstandsmaterial einen spezifischen elektrischen Widerstand (6) aufweist, der kleiner ist als 2·10⁻⁴ Ω·m, 2·10⁻⁵ Ω·m oder 2·10⁻⁶ Ω·m, und/oder
j) **dass** das Leitermaterial einen spezifischen elektrischen Widerstand (6) aufweist, der kleiner ist als 10⁻⁵ Ω·m, 10⁻⁶ Ω·m oder 10⁻⁷ Ω·m.

9. Beschichtungsverfahren zur Beschichtung (7) eines elektrischen Widerstands (6), insbesondere eines Widerstands (6) nach einem der vorhergehenden Ansprüche, mit den folgenden Schritten:
a) Aufbringen einer metallischen Beschichtung (7) auf ein Widerstandselement (3) des elektrischen Widerstands (6), um einen Korrosionsschutz zu erreichen und/oder die Lötbarkeit zu verbessern,
**dadurch gekennzeichnet,**
b) dass die metallische Beschichtung (7) ohne eine Isolationsschicht (5) direkt auf die gesamte freie Oberfläche des Widerstandselements (3) aufgebracht wird, und
c) dass das metallische Material der Beschichtung (7) einen größeren spezifischen elektrischen Widerstand (6) aufweist als das Widerstandsmaterial des Widerstandselements (3).

10. Beschichtungsverfahren nach Anspruch 9, **dadurch gekennzeichnet, dass** der Widerstand (6) galvanisch mit der metallischen Beschichtung (7) beschichtet wird, insbesondere durch eine Einzelbeschichtung und durch ein Trommelgalvanik-Verfahren.

11. Beschichtungsverfahren nach Anspruch 9, **dadurch gekennzeichnet, dass** der Widerstand (6) chemisch mit der metallischen Beschichtung (7) beschichtet wird.

## Claims

1. Resistor (6), particularly a low-resistance current-measuring resistor comprising
a) a first connection part (1) consisting of a conductor material for introducing an electrical current (I) into the resistor (6),
b) a second connection part (2) consisting of a conductor material for discharging the electrical current (I) from the resistor (6),
c) a resistor element (3) consisting of a resistor material, the resistor element (3) being arranged in the direction of the current between the first connection part (1) and the second connection part (2),
d) a coating (7) of the resistor (6) consisting of a metallic material to achieve corrosion protection and/or to improve solderability,
**characterized in that**
e) the metallic coating (7) is applied without an insulation layer (5) directly to the entire free surface of the resistor element (3), an
f) the metallic material of the coating (7) has a greater specific electrical resistance (6) than the resistor material of the resistor element (3).

2. Resistor (6) according to claim 1, **characterized in that** the metallic coating (7) has a layer thickness of less than 50 µm, 20 µm, 10 µm, 5 µm, 1 µm, 500 nm or 200 nm.

3. Resistor (6) according to any of the previous claims, **characterized in that**
a) the metallic coating (7) together with the resistor element (3) forms an electrical by-pass (IN) between the two connection parts,
b) the by-pass (IN) through the metallic coating (7) has a specific electrical resistance value (RN),
c) the resistor element (3) has a specific resistance value (RH) between the two connection parts,
d) the resistance value (RN) of the by-pass is lower than 10 %, 5 %, 1 %, 0.5 % or 0.2 % of the resistance value (RH) of the resistor element (3).

4. Resistor (6) according to any of the previous claims, **characterized in that** the metallic material of the coating (7) contains at least one of the following materials:
a) nickel,
b) nickel-phosphorus, particularly comprising a phosphorus content of 6-8 %,
c) gold, particularly flash gold,
d) silver,
e) palladium,
f) an alloy of the aforementioned materials.

5. Resistor (6) according to any of the previous claims, **characterized in that**
a) the resistor (6) without the metallic coating (7) has an electrical resistance value with a specific temperature coefficient,
b) the resistor (6) with the metallic coating (7) has an electrical resistance value with a specific temperature coefficient,
c) the temperature coefficient with the coating (7) differs by less than 20 %, 10 %, 5 % or 1 % from the temperature coefficient without the coating (7).

6. Resistor (6) according to any of the previous claims, **characterized in that** the metallic coating (7) completely envelops the resistor (6) including the connection parts (1, 2) and the resistor element (3).

7. Resistor (6) according to any of the previous claims, **characterized in that** the metallic coating (7) is solderable, weldable, bondable and/or corrosion-resistant.

8. Resistor (6) according to any of the previous claims **characterized in that**
a) the conductor material of the connection parts (1, 2) is copper or a copper alloy and/or
b) the resistor material of the resistor element (3) is a copper alloy, particularly a copper-manganese-nickel alloy, particularly Cu84Ni4Mn12 and/or
c) the resistor material of the resistor element (3) is a nickel alloy, particularly NiCr or CuNi and/or
d) the resistor element (3) is electrically and mechanically connected to the two connection parts (1, 2), particularly through a welded connection and/or
e) the two connection parts (1, 2) are arranged on opposite sides of the resistor element (3) and/or
f) the connection parts (1, 2) and/or the resistor element (3) are plate-shaped and/or
g) the plate-shaped connection parts (1, 2) and/or the plate-shaped resistor element (3) are flat or curved and/or
h) the resistor material has a specific electrical resistance with a temperature coefficient of less than 5·10⁻⁴ K⁻¹, 2·10⁻⁴ K⁻¹, 1·10⁻⁴ K⁻¹ or 5·10⁻⁵ K⁻¹ and/or
i) the resistor material has a specific electrical resistance (6) which is less than 2·10⁻⁴ Ω·m, 2·10⁻⁵ Ω·m or 2·10⁻⁶ Ω·m and/or
j) the conductor material has a specific electrical resistance (6) which is less than 10⁻⁵ Ω·m, 10⁻⁶ Ω·m or 10⁻⁷ Ω·m.

9. Coating method for coating (7) an electrical resistor (6), particularly a resistor (6) according to any of the preceding claims, comprising the following steps:
a) applying a metallic coating (7) to a resistor element (3) of the electrical resistor (6) to achieve corrosion protection and/or to improve solderability,
**characterized in that**
b) the metallic coating (7) is applied without an insulation layer (5) directly to the entire free surface of the resistor element (3), and
d) the metallic material of the coating (7) has a greater specific electrical resistance (6) than the resistor material of the resistor element (3).

10. Coating method according to claim 9, **characterized in that** the metallic coating (7) is applied as a galvanized coating to the resistor (6), particularly as a single coating and using the barrel plating method.

11. Coating method according to claim 9, **characterized in that** the metallic coating (7) is applied chemically to the resistor (6).

## Revendications

1. Résistance (6), en particulier résistance de mesure de courant à faible impédance, comprenant
a) une première partie de connexion (1) composée d'un matériau conducteur servant à acheminer un courant électrique (I) à l'intérieur de la résistance (6),
b) une deuxième partie de connexion (2) composée d'un matériau conducteur servant à dévier le courant électrique (I) hors de la résistance (6),
c) un élément de résistance (3) composé d'un matériau de résistance, sachant que l'élément de résistance (3) est disposé dans la direction de flux entre la première partie de connexion (1) et la deuxième partie de connexion (2),
d) un revêtement (7) de la résistance (6) composé d'un matériau métallique afin d'obtenir une protection contre la corrosion et/ou d'améliorer l'aptitude au brasage,
**caractérisée en ce**
e) **que** le revêtement (7) métallique est appliqué directement sur la totalité de la surface dégagée de l'élément de résistance (3) sans une couche d'isolation (5), et
f) en ce que le matériau métallique du revêtement (7) présente une résistance (6) électrique spécifique plus grande que le matériau de résistance de l'élément de résistance (3).

2. Résistance (6) selon la revendication 1, **caractérisée en ce que** le revêtement (7) métallique présente une épaisseur de couche inférieure à 50 µm, 20 µm, 10 µm, 5 µm, 1 µm, 500 nm ou 200 nm.

3. Résistance (6) selon l'une quelconque des revendications précédentes,
**caractérisée en ce**
a) **que** le revêtement (7) métallique forme, outre l'élément de résistance (3), un shunt (IN) électrique entre les deux parties de connexion,
b) en ce que le shunt (IN) au-dessus du revêtement (7) métallique présente une valeur de résistance (RN) électrique définie,
c) en ce que l'élément de résistance (3) présente entre les deux parties de connexion une valeur de résistance (RH) définie,
d) en ce que la valeur de résistance (RN) du shunt est inférieure à 10 %, 5 %, 1 %, 5‰ ou 2‰ de la valeur de résistance (RH) de l'élément de résistance (3).

4. Résistance (6) selon l'une quelconque des revendications précédentes, **caractérisée en ce que** le matériau métallique du revêtement (7) contient au moins un des matériaux qui suit :
a) du nickel,
b) du phosphore nickel, en particulier comprenant une teneur en phosphore de 6 - 8 %,
c) de l'or, en particulier du plaqué or,
d) de l'argent,
e) du palladium,
f) un alliage des matériaux mentionnés ci-avant.

5. Résistance (6) selon l'une quelconque des revendications précédentes,
**caractérisée en ce**
a) **que** la résistance (6) sans le revêtement (7) métallique présente une valeur de résistance électrique présentant un coefficient de température défini,
b) en ce que la résistance (6) avec le revêtement (7) métallique présente une valeur de résistance électrique présentant un coefficient de température défini,
c) en ce que le coefficient de température avec le revêtement (7) diffère du coefficient de température sans le revêtement (7) d'une valeur inférieure à 20 %, 10 %, 5 % ou 1 %.

6. Résistance (6) selon l'une quelconque des revendications précédentes, **caractérisée en ce que** le revêtement (7) métallique enveloppe complètement la résistance (6) y compris les parties de connexion (1, 2) et l'élément de résistance (3).

7. Résistance (6) selon l'une quelconque des revendications précédentes, **caractérisée en ce que** le revêtement (7) métallique peut être brasé, soudé, lié et/ou est résistant à la corrosion.

8. Résistance (6) selon l'une quelconque des revendications précédentes,
**caractérisée en ce**
a) **que** le matériau conducteur des parties de connexion (1, 2) est du cuivre ou un alliage de cuivre, et/ou
b) en ce que le matériau de résistance de l'élément de résistance (3) est un alliage de cuivre, en particulier un alliage de cuivre, manganèse, nickel, en particulier Cu84Ni4Mn12, et/ou
c) en ce que le matériau de résistance de l'élément de résistance (3) est un alliage de nickel, en particulier NiCr ou CuNi, et/ou
d) en ce que l'élément de résistance (3) est assemblé électriquement et mécaniquement aux deux parties de connexion (1, 2), en particulier par un assemblage par soudage, et/ou
e) en ce que les deux parties de connexion (1, 2) sont disposées sur des côtés se faisant face de l'élément de résistance (3), et/ou
f) en ce que les parties de connexion (1, 2) et/ou l'élément de résistance (3) présentent une forme de plaque, et/ou
g) en ce que les parties de connexion (1, 2) en forme de plaque et/ou l'élément de résistance (3) en forme de plaque sont plats ou pliés, et/ou
h) en ce que le matériau de résistance présente une résistance électrique spécifique présentant un coefficient de température inférieur à 5·10⁻⁴K⁻¹, 2.10⁻⁴K⁻¹, 1.10⁻⁴K⁻¹ ou 5.10⁻⁵K⁻¹, et/ou
i) en ce que le matériau de résistance présente une résistance (6) électrique spécifique, qui est inférieure à 2.10⁻⁴ Ω·m, 2.10⁻⁵ Ω·m ou 2.10⁻⁶ Ω·m, et/ou
j) en ce que le matériau conducteur présente une résistance (6) électrique spécifique, qui est inférieure à 10⁻⁵ Ω·m, 10⁻⁶ Ω·m ou 10⁻⁷ Ω·m.

9. Procédé de revêtement servant à pourvoir d'un revêtement (7) une résistance (6) électrique, en particulier une résistance (6) selon l'une quelconque des revendications précédentes, comprenant les étapes suivantes consistant à :
a) appliquer un revêtement (7) électrique sur un élément de résistance (3) de la résistance (6) électrique afin d'obtenir une protection contre la corrosion et/ou d'améliorer l'aptitude au brasage,
caractérisé en ce
b) que le revêtement (7) métallique est appliqué directement sur la totalité de la surface dégagée de l'élément de résistance (3) sans une couche d'isolation (5), et
c) en ce que le matériau métallique du revêtement (7) présente une résistance (6) électrique spécifique plus grande que le matériau de résistance de l'élément de résistance (3).

10. Procédé de revêtement selon la revendication 9, **caractérisé en ce que** la résistance (6) est pourvue du revêtement (7) métallique par voie galvanique, en particulier par une action unique de revêtement et par un procédé galvanique à tambour.

11. Procédé de revêtement selon la revendication 9, **caractérisé en ce que** la résistance (6) est pourvue du revêtement (7) métallique par voie chimique.
